# EUROPÄISCHE PATENTSCHRIFT

(11) **EP 2 332 396 B1**
(45) Veröffentlichungstag und Bekanntmachung des Hinweises auf die Patenterteilung: **19.06.2019**
(21) Anmeldenummer: 09781217.6
(22) Anmeldetag: 29.07.2009
(51) Int. Cl.: H05K 3/34, H01L 23/495

(54) **GEHÄUSE FÜR EINE ELEKTRISCHE SCHALTUNG**
HOUSING FOR AN ELECTRICAL CIRCUIT
BOÎTIER POUR UN CIRCUIT ÉLECTRIQUE

(30) Priorität: 24.09.2008 DE 102008042335
(43) Veröffentlichungstag der Anmeldung: 15.06.2011
(73) Patentinhaber: Robert Bosch GmbH, 70442 Stuttgart (DE)
(72) Erfinder: STRUCHHOLZ, Michael, 72762 Reutlingen (DE); JOBERT, Tristan, 72766 Reutlingen (DE); OFFTERDINGER, Klaus, 70619 Stuttgart (DE); KLAUS, Thomas, 72074 Tuebingen (DE); DITTMANN, Dirk, 76344 Eggenstein (DE)
(86) Internationale Anmeldenummer: PCT/EP2009/059778
(87) Internationale Veröffentlichungsnummer: WO 2010/034545

(56) Entgegenhaltungen:
- US-A- 5 109 269
- US-A- 5 281 851
- US-A- 5 291 375
- US-A- 5 412 157
- US-A- 5 471 097
- US-A- 5 789 280
- US-A- 6 060 780
- US-A- 6 084 291
- US-A1- 2004 201 081
- US-A1- 2006 016 619
- US-B1- 6 342 729

## Beschreibung

Die Erfindung betrifft ein Gehäuse für eine elektrische Schaltung gemäß Patentanspruch 1 und gemäß Patentanspruch 2.

### Stand der Technik

Im Stand der Technik sind Gehäuse für elektrische Schaltungen, insbesondere Sensoren oder integrierte Schaltungen bekannt, die auf Leiterplatten befestigt werden. Das Gehäuse ist im allgemeinen aus Kunststoff ausgebildet und es sind elektrisch leitende Beinchen aus dem Gehäuse herausgeführt, die zur Befestigung auf der Leiterplatte und zur elektrischen Kontaktierung der elektrischen Schaltung vorgesehen sind, die im Gehäuse angeordnet ist. Die Gehäuse weisen auf zwei gegenüberliegenden Seiten eine Reihe von Beinchen auf.

Insbesondere bei der Anordnung der Gehäuse in einem Kraftfahrzeug sind die Gehäuse Schwingungen, insbesondere Störbeschleunigungen ausgesetzt. Bei der Verwendung eines Sensors, insbesondere eines Inertialsensors können Störbeschleunigungen im Bereich der Eigenfrequenz die Empfindlichkeit des Sensors nachteilig beeinflussen.

Aus US 5,789,280 ist ein Gehäuse mit einer elektronischen Schaltung bekannt, wobei das Gehäuse an vier Seiten elektrische Beinchen zu Kontaktierung der Schaltung aufweist. Für eine Versteifung der Beinchen sind Versteifungselemente vorgesehen, die mehrere Beinchen einer Seite miteinander verbinden.

Aus US 5,412,157 ist ein Halbleiterbaustein mit einem Gehäuse mit einer elektronischen Schaltung bekannt. Am Gehäuse sind auf vier Seiten elektrische Beinchen ausgebildet, die zur elektrischen Kontaktierung der Schaltung vorgesehen sind. Für eine Versteifung der Beinchen sind Querrippen vorgesehen, die teilweise im Gehäuse angeordnet sind.

Aus US 2006/0016619 A1 ist ein Gehäuse mit einer elektronischen Schaltung bekannt, wobei das Gehäuse mehrere Beinchen zur elektrischen Kontaktierung der Schaltung aufweist. Zusätzlich sind weitere Beinchen vorgesehen, die nicht zur elektrischen Kontaktierung, sondern nur zur mechanischen Befestigung des Gehäuses dienen. Die Beinchen weisen einen breiteren Querschnitt als die zur elektrischen Kontaktierung vorgesehen Beinchen auf.

Aus US 6,060,780 ist ein Halbleiterchip bekannt, der mehrere elektrische Kontakte aufweist. Ein Teil der elektrischen Kontakte ist für eine elektrische Kontaktierung der Schaltung des Halbleiterchips vorgesehen. Weitere Kontakte sind zur Verbesserung der mechanischen Befestigung des Halbleiterbausteins vorgesehen.

Aus US 5,291,375 ist ein Gehäuse für eine elektrische Schaltung bekannt, bei der Beinchen aus dem Gehäuse zur elektrischen Kontaktierung herausragen, die auf gegenüberliegenden Seiten des Gehäuses angeordnet sind. Ferner sind weitere Beinchen, die nicht elektrisch mit der Schaltung verbunden sind, vorgesehen, die als mechanische Befestigungsmittel des Gehäuses dienen. Die weiteren Beinchen sind an einer Querseite des Gehäuses angeordnet, wobei auch Beinchen an der Querseite angeordnet sind.

### Offenbarung der Erfindung

Die Aufgabe der Erfindung besteht darin, den Einfluss von Schwingungen, insbesondere Störbeschleunigungen auf elektrische Schaltungen, insbesondere Sensoren zu reduzieren.

Die Aufgabe der Erfindung wird durch das Gehäuse des Anspruchs 1 gelöst. Dieses Gehäuse unterscheidet sich von der US 5,291,375 dadurch, dass die weiteren Beinchen an einer Querseite des Gehäuses angeordnet sind, an der keine Beinchen zur elektrischen Kontaktierung angeordnet sind.

Ein Vorteil der erfindungsgemäßen Gehäuse besteht darin, dass die Empfindlichkeit gegenüber Störbeschleunigungen reduziert ist.

Dies wird in einem Ausführungsbeispiel dadurch erreicht, dass ein weiteres Beinchen vorgesehen ist, das nicht elektrisch mit der Schaltung des Gehäuses verbunden ist, sondern als mechanisches Befestigungsmittel für das Gehäuse insbesondere zur Befestigung auf einer Leiterplatte vorgesehen ist. Durch das weitere Beinchen wird die Empfindlichkeit zur Schwingungsanregung reduziert. Insbesondere verschiebt sich die Eigenfrequenz des Gehäuses zu höheren Frequenzen.

Weitere Ausführungsformen der Erfindung sind in den abhängigen Ansprüchen angegeben.

In einer weiteren Ausführungsform ist ein Verbindungsstück zwischen zwei weitere Beinchen des Gehäuses vorgesehen. Durch das Verbindungsstück wird ebenfalls die Empfindlichkeit zur Anregung zu Schwingungen reduziert. Durch das Verbindungsstück wird eine erhöhte Steifigkeit zwischen den zwei weiteren Beinchen bewirkt. Somit ist insgesamt die mechanische Befestigung des Gehäuses steifer, so dass auch hier die Eigenfrequenz zu einer höheren Frequenz verschoben ist.

In einer weiteren Ausführungsform ist die elektrische Schaltung als Sensor, insbesondere als Inertialsensor für einen Airbag- oder ESP-System ausgebildet. Insbesondere bei Inertialsensoren ist es vorteilhaft, den Einfluss von Störbeschleunigungen zu reduzieren. In einer weiteren Ausführungsform sind alle weiteren Beinchen einer Seite über wenigstens ein Verbindungsstück miteinander verbunden. Auf diese Weise wird eine hohe Steifigkeit der Beinchen erreicht.

In einer weiteren Ausführungsform sind Gruppen von miteinander verbundenen Beinchen vorgesehen, wobei eine erste Gruppe zwei Beinchen und eine zweite Gruppe drei Beinchen aufweist. Abhängig von der verwendeten Ausführungsform kann diese Anordnung eine vorteilhafte Reduzierung der Störempfindlichkeit bewirken.

In einer weiteren Ausführungsform sind Gruppen von weiteren Beinchen auf einer Seite des Gehäuses mechanisch über ein Verbindungsstück miteinander verbunden, wobei eine erste Gruppe zwei Beinchen und eine zweite Gruppe drei Beinchen aufweist. Auch in dieser Ausführungsform kann eine vorteilhafte Redzierung der Störempfindlichkeit bewirkt werden.

In einer weiteren Ausführungsform ist das Verbindungsstück wenigstens teilweise im Gehäuse angeordnet. Somit kann eine zuverlässige und einfache Befestigung des Verbindungsstückes erreicht werden.

In einer weiteren Ausführungsform ist das Verbindungsstück einstückig mit den verbundenen Beinchen oder mit den verbundnen weiteren Beinchen ausgebildet. Auf diese Weise ist eine einfache Herstellung des Verbindungsstückes möglich.

Zudem kann in einer weiteren Ausführungsform das Verbindungsstück aus einem elektrisch isolierenden Material gebildet sein, so dass auch Beinchen mit dem Verbindungsstück verbunden werden können, die elektrisch mit der Schaltung verbunden sind, ohne dass ein Kurzschluss zwischen den Beinchen auftritt. Somit kann der Einfluss von Störbeschleunigungen reduziert werden, ohne dass weitere Beinchen erforderlich sind, die nicht für eine elektrische Kontaktierung benötigt werden.

### Kurze Beschreibung der Zeichnungen

Es zeigen:
- Fig. 1: ein erstes Ausführungsbeispiel eines Gehäuses,
- Fig. 2: eine Seitenansicht des Gehäuses,
- Fig. 3: ein nicht erfinderisches Beispiel eines Gehäuses,
- Fig. 4: eine zweite Ausführungsform eines Gehäuses, und
- Fig. 5: ein zweites nicht erfinderisches Beispiel eines Gehäuses.

### Ausführungsbeispiele der Erfindung

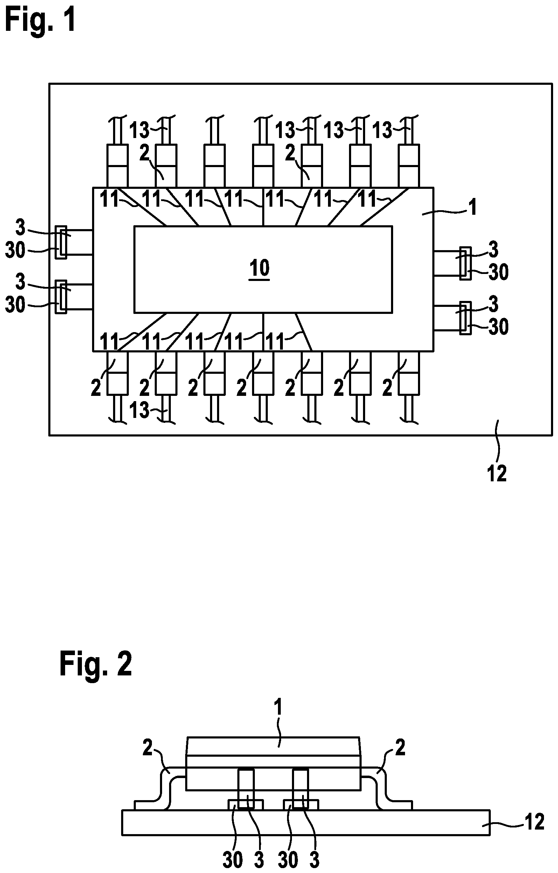

Figur 1 zeigt in einer schematischen Darstellung eine Leiterplatte 12, auf der elektrische Leitungen 13 und nicht dargestellte elektrische Bauteile und/oder elektrische Schaltungen angeordnet sind. Auf der Leiterplatte 12 ist ein Gehäuse 1 mit einer elektrischen Schaltung 10 angeordnet. Das Gehäuse 1 kann aus einem Kunststoff gebildet sein, der die elektrische Schaltung 10 vollständig umgibt. Die elektrische Schaltung 10 kann in Form eines Sensors, insbesondere eines Inertialsensors ausgebildet sein. Inertialsensoren werden beispielsweise als Teil eines Airbagsystems oder ESP-Systems in Kraftfahrzeugen eingesetzt, um Messgrößen für eine Beschleunigung und eine Drehrate zu ermitteln. Inertialsensoren können entweder als integraler Bestandteil von Steuergeräten oder als eigenständige Sensoren ausgebildet sein. Somit kann im Gehäuse 1 die elektrische Schaltung aus einer Steuerschaltung in Form eines Steuergerätes und zusätzlich eines Sensors, beispielsweise in Form eines Inertialsensors ausgebildet sein. Inertialsensoren können beispielsweise in Form von Drehratensensoren ausgebildet sein, die als Messeffekt eine Coreolis-Beschleunigung erfassen. Dazu weist der Sensor eine Masse auf, die mithilfe von Federelementen schwingfähig angeordnet ist. Die Federelemente sind in der Figur 1 nicht dargestellt.

Weiterhin weist das Gehäuse elektrische Anschlüsse in Form von Beinchen 2 auf, die mit den elektrischen Leitungen 13 der Leiterplatte 12 verbunden sind. Dazu sind die Beinchen beispielsweise mit der Leiterplatte 12 verklebt oder verlötet. Zudem ist wenigstens ein Teil der Beinchen über weitere elektrische Leitungen 11 mit der elektrischen Schaltung 10 elektrisch leitend verbunden. Mithilfe der Beinchen 2 können elektrische Signale zwischen der Leiterplatte 12 und der elektrischen Schaltung 10 ausgetauscht werden. Zudem dienen die Beinchen zur mechanischen Befestigung des Gehäuses 1. Weiterhin weist das Gehäuse 1 weitere Beinchen 3 die aus dem Gehäuse 1 herausragen und mit der Leiterplatte 12 mechanisch verbunden sind. Die Verbindung zwischen den weiteren Beinchen 3 wird mithilfe eines Verbindungsmittels 30 hergestellt. Das Verbindungsmittel 30 kann beispielsweise in Form einer Steckverbindung, Verklebung oder Verlötung ausgebildet sein. Die weiteren Beinchen 3 sind mechanisch mit der Leiterplatte 12 verbunden, aber nicht an weitere Leitungen 11 und/oder nicht an elektrische Leitungen 13 angeschlossen und stehen somit nicht in Verbindung mit der elektrischen Schaltung 10. Die weiteren Beinchen dienen nur der mechanischen Befestigung des Gehäuses 1 auf der Leiterplatte 12.

In dem dargestellten Ausführungsbeispiel sind die Beinchen an gegenüberliegenden Längsseiten des Gehäuses 1 angeordnet, wobei jeweils sieben Beinchen vorgesehen sind. Die weiteren Beinchen 3 sind an den kürzeren Querseiten des Gehäuses 1 gegenüberliegend angeordnet. In dem dargestellten Ausführungsbeispiel sind jeweils zwei weitere Beinchen 3 an einer Seite des Gehäuses angeordnet. Abhängig von der gewählten Ausführungsform können auch mehr oder weniger weitere Beinchen 3 auf einer Seite vorgesehen sein. Zudem ist es auch möglich, weitere Beinchen 3 nur an einer Seite des Gehäuses auszubilden.

Aufgrund der Anordnung der weiteren Beinchen 3 wird die Empfindlichkeit des Gehäuses bzw. der elektrischen Schaltung 10 für Störbeschleunigungen reduziert. Insbesondere wird durch die weiteren Beinchen die Eigenfrequenz zur Anregung von Schwingungen des Gehäuses verhindert. Beispielsweise wird die Eigenfrequenz zu höheren Frequenzen verschoben. Somit wird die Auswirkung von Störbeschleunigungen auf die elektrische Schaltung, insbesondere auf Sensoren reduziert.

Die Beinchen 2 und die weiteren Beinchen 3 sind beispielsweise aus einem Metallstreifen hergestellt und in das Gehäuse 1 eingegossen. Dabei kann beispielsweise einen so genannte Lead-Frame-Technologie verwendet werden.

Figur 2 zeigt in einer Seitenansicht das Gehäuse 1 mit dem Beinchen 2 und den weiteren Beinchen 3.

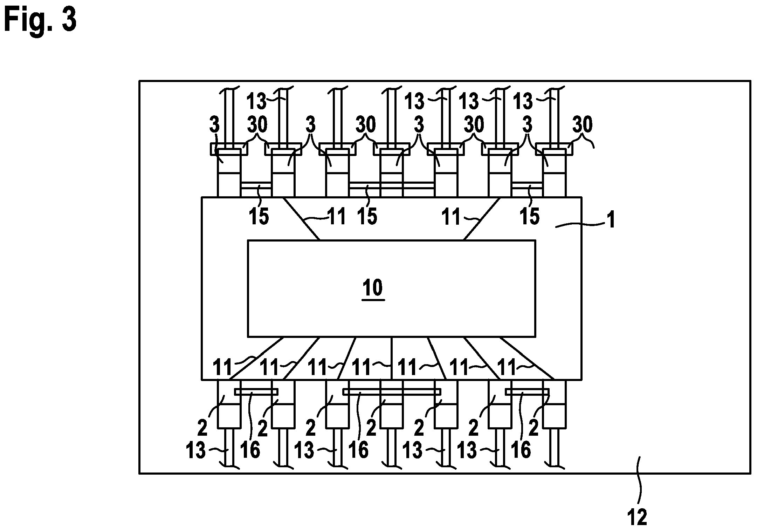

Figur 3 zeigt ein Beispiel eines Gehäuses 1 mit einer elektrischen Schaltung 10. In diesem Beispiel sind die Beinchen 2 die eine elektrische Verbindung zur elektrischen Schaltung 10 ermöglichen, auf einer Längsseite des Gehäuses 1 angeordnet. Die weiteren Beinchen 3 sind auf der gegenüberliegenden Seite angeordnet. Weiterhin sind Gruppen von weiteren Beinchen über Verbindungsstücke 15 miteinander verbunden. Im dargestellten Beispiel sind zwei Gruppen von zwei weiteren Beinchen 3 und eine Gruppen von drei weiteren Beinchen 3 die über ein Verbindungsstück 15 miteinander verbunden sind, angeordnet. Auf diese Weise wird zusätzlich die Steifigkeit der weiteren Beinchen 3 erhöht. Abhängig von dem gewählten Beispiel können auch alle weiteren Beinchen 3 einer Seite des Gehäuses 1 miteinander über ein Verbindungsstück 15 verbunden sein. Das Verbindungsstück 15 kann beispielsweise einstückig mit den weiteren Beinchen ausgebildet sein und ebenfalls aus einem Blechstück gebildet sein. Abhängig von dem gewählten Beispiel kann das Verbindungsstück auch aus einem nicht elektrisch leitenden Material ausgebildet sein.

Ein weiteres Verbindungsstück 16, das aus nicht elektrisch leitendem Material hergestellt ist, kann dabei auch Gruppen von Beinchen 2 mechanisch miteinander verbinden, ohne eine elektrisch leitende Verbindung zwischen den einzelnen Beinchen 2 herzustellen. In dem Beispiel der Fig. 3 sind zwei Gruppen von zwei Beinchen 2 und eine Gruppe von drei Beinchen 2 über ein elektrisch nicht leitendes Verbindungsstück 16 miteinander verbunden. Auch durch dieses Beispiel wird die Steifigkeit der Beinchen 2 erhöht und somit die Empfindlichkeit für eine Störbeschleunigung reduziert. Abhängig von dem gewählten Beispiel können auch andere Kombinationen von Anzahlen von Beinchen 2 zur Bildung von Gruppen verwendet werden. Insbesondere können alle Beinchen 2 einer Seite über ein elektrisch nicht leitendes weiteres Verbindungsstück 16 miteinander verbunden sein. Somit wird auch mithilfe der weiteren Verbindungsstücke die Eigenfrequenz zu höheren Frequenzen verschoben und damit die Empfindlichkeit reduziert.

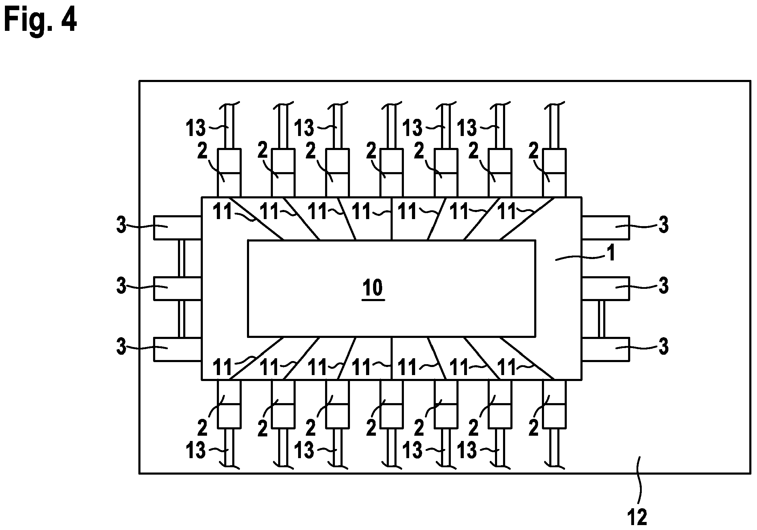

Fig. 4 zeigt eine weitere Ausführungsform eines Gehäuses 1. Bei dieser Ausführungsform sind an jeder schmalen Seite des Gehäuses 1 jeweils drei weitere Beinchen 3 angeordnet. In dieser Ausführungsform sind auf einer Seite zwei weitere Beinchen 3 über ein Verbindungsstück 15 miteinander verbunden. Auf der gegenüberliegenden Seite sind drei weitere Beinchen 6 über ein oder zwei Verbindungsstücke 15 miteinander verbunden. Auch in dieser Ausführungsform ist die Empfindlichkeit gegenüber Störbeschleunigungen reduziert.

Abhängig von der gewählten Ausführungsform können die Verbindungsstücke 15 oder die weiteren Verbindungsstücke 16 auch teilweise in das Gehäuse 1 eingebettet werden. Dadurch wird eine einfache Fixierung der Verbindungsstücke 15 und der weiteren Verbindungsstücke 16 ermöglicht.

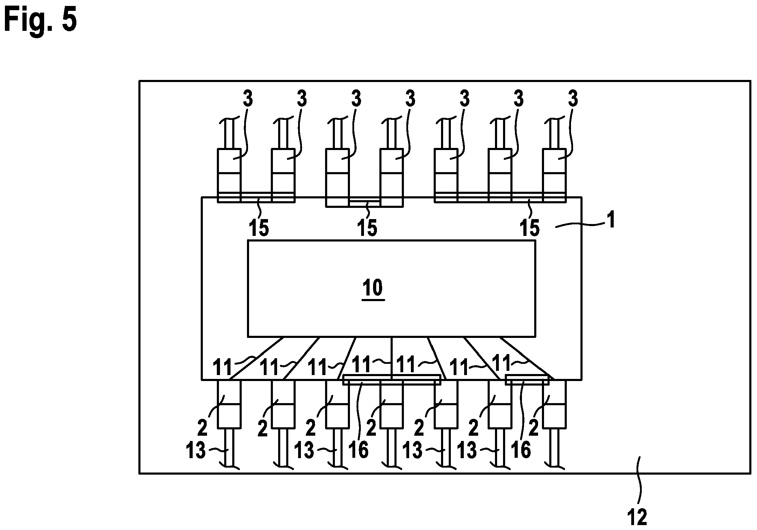

Fig. 5 zeigt ein entsprechendes Beispiel, bei der weitere Beinchen 3 in Gruppen von zwei und drei weiteren Beinchen über ein Verbindungsstück 15 miteinander verbunden sind, wobei das Verbindungsstück 15 wenigstens teilweise im Gehäuse 1 angeordnet ist. Anstelle der Verbindungsstücke 15 können auch weitere Verbindungsstücke 16 vorgesehen sein, die die Gruppen von weiteren Beinchen verbinden.

Zudem sind weitere Verbindungsstücke 16 aus nicht elektrisch leitendem Material, beispielsweise Kunststoff ausgebildet, die teilweise im Gehäuse 1 angeordnet sind und die Gruppen von Beinchen 2 mechanisch miteinander verbunden.

Abhängig von dem gewählten Beispiel können die Verbindungsstücke 15 alle weiteren Beinchen einer Seite oder die weiteren Verbindungsstücke 16 alle Beinchen einer Seite des Gehäuses 1 mechanisch miteinander verbinden.

Abhängig von dem gewählten Beispiel können auch die Verbindungsstücke 15 aus elektrisch nicht leitendem Material, insbesondere aus Kunststoff ausgebildet sein.

## Patentansprüche

1. Gehäuse (1) für eine elektrische Schaltung (10), insbesondere für einen Sensor, wobei Beinchen (2) aus dem Gehäuse (1) zur elektrischen Kontaktierung der Schaltung (10) herausragen, wobei weitere Beinchen (3) vorgesehen sind, die nicht elektrisch mit der Schaltung verbunden sind, sondern als mechanisches Befestigungsmittel des Gehäuses insbesondere auf einer Leiterplatte dienen, wobei das Gehäuse (1) vier Seiten aufweist, wobei die Beinchen (2) auf gegenüber liegenden Seiten des Gehäuses angeordnet sind, wobei, dass die weiteren Beinchen (3) an wenigstens einer Querseite des Gehäuses (1) angeordnet sind, **dadurch gekennzeichnet, dass** an der Querseite mit den weiteren Beinchen (3) keine Beinchen (2) zur Kontaktierung angeordnet sind.

2. Gehäuse nach Anspruch (1), wobei wenigstens zwei Beinchen (2) über ein Verbindungsstück (16) miteinander mechanisch verbunden sind.

3. Gehäuse nach Anspruch 1 oder 2, wobei die Schaltung als Inertialsensor für ein Airbag- oder ESP-System ausgebildet ist.

4. Gehäuse nach einem der Ansprüche 1 bis 3, wobei wenigstens zwei weitere Beinchen (3) über ein Verbindungsstück (15) miteinander verbunden sind.

5. Gehäuse nach einem der Ansprüche 1 bis 4, wobei Gruppen von weiteren Beinchen (3) auf einer Seite des Gehäuses (1) mechanisch über wenigstens ein Verbindungsstück (15) miteinander verbunden sind, wobei eine erste Gruppe zwei weitere Beinchen (3) und eine zweite Gruppe drei weitere Beinchen (3) aufweist.

6. Gehäuse nach einem der Ansprüche 2 bis 5, wobei das Verbindungsstück (15, 16) wenigstens teilweise im Gehäuse (1) angeordnet ist.

7. Gehäuse nach einem der Ansprüche 2 bis 6, wobei das Verbindungsstück (15,16) einstückig mit den verbundenen Beinchen (2) oder mit den verbundenen weiteren Beinchen (3) ausgebildet ist.

8. Gehäuse nach einem der Ansprüche 2 bis 7, wobei das Verbindungsstück (16) aus einem elektrisch isolierenden Material gebildet ist.

9. Gehäuse nach einem der Ansprüche 1 bis 8, wobei Gruppen von Beinchen (2) auf einer Seite des Gehäuses (1) mechanisch über wenigstens ein Verbindungsstück (16) miteinander verbunden sind, wobei eine erste Gruppe zwei Beinchen (2) und eine zweite Gruppe drei Beinchen (2) aufweist.

## Claims

1. Housing (1) for an electrical circuit (10), in particular for a sensor, wherein legs (2) protrude out of the housing (1) for the purpose of making electrical contact with the circuit (10), wherein further legs (3) are provided, which further legs are not electrically connected to the circuit but rather serve as mechanical fastening means of the housing, in particular on a printed circuit board, wherein the housing (1) has four sides, wherein the legs (2) are arranged on opposite sides of the housing, wherein the further legs (3) are arranged on at least one transverse side of the housing (1), **characterized in that** no legs (2) for the purpose of making contact are arranged on the transverse side with the further legs (3).

2. Housing according to Claim 1, wherein at least two legs (2) are mechanically connected to one another by means of a connecting piece (16).

3. Housing according to Claim 1 or 2, wherein the circuit is designed as an inertial sensor for an airbag or ESP system.

4. Housing according to one of Claims 1 to 3, wherein at least two further legs (3) are connected to one another by means of a connecting piece (15).

5. Housing according to one of Claims 1 to 4, wherein groups of further legs (3) on one side of the housing (1) are mechanically connected to one another by means of at least one connecting piece (15), wherein a first group has two further legs (3) and a second group has three further legs (3).

6. Housing according to one of Claims 2 to 5, wherein the connecting piece (15, 16) is at least partially arranged in the housing (1).

7. Housing according to one of Claims 2 to 6, wherein the connecting piece (15, 16) is formed in one piece with the connected legs (2) or with the connected further legs (3) .

8. Housing according to one of Claims 2 to 7, wherein the connecting piece (16) is formed from an electrically insulating material.

9. Housing according to one of Claims 1 to 8, wherein groups of legs (2) on one side of the housing (1) are mechanically connected to one another by means of at least one connecting piece (16), wherein a first group has two legs (2) and a second group has three legs (2).

## Revendications

1. Boîtier (1) pour un circuit électrique (10), notamment pour un capteur, des petites pattes (2) faisant saillie hors du boîtier (1) servant à la mise en contact électrique du circuit (10), des petites pattes supplémentaires (3) étant présentes, lesquelles ne sont pas reliées électriquement au circuit, mais servent de moyens de fixation mécaniques du boîtier, notamment sur un circuit imprimé, le boîtier (1) possédant quatre côtés, les petites pattes (2) étant disposées sur des côtés opposés du boîtier, les petites pattes supplémentaires (3) étant disposées sur au moins un côté transversal du boîtier (1), **caractérisé en ce qu'**aucune petite patte (2) servant à la mise en contact électrique n'est disposée au niveau du côté transversal pourvu des petites pattes supplémentaires (3).

2. Boîtier selon la revendication 1, au moins deux petites pattes (2) étant reliées mécaniquement l'une à l'autre par le biais d'un élément de liaison (16).

3. Boîtier selon la revendication 1 ou 2, le circuit étant réalisé sous la forme d'un capteur inertiel pour un système de coussin gonflable de sécurité ou ESP.

4. Boîtier selon l'une des revendications 1 à 3, au moins deux petites pattes supplémentaires (3) étant reliées l'une à l'autre par le biais d'un élément de liaison (15).

5. Boîtier selon l'une des revendications 1 à 4, des groupes de petites pattes supplémentaires (3) étant reliés mécaniquement entre eux sur un côté du boîtier (1) par le biais d'au moins un élément de liaison (15), un premier groupe comportant deux petites pattes supplémentaires (3) et un deuxième groupe trois petites pattes supplémentaires (3).

6. Boîtier selon l'une des revendications 2 à 5, l'élément de liaison (15, 16) étant au moins partiellement disposé dans le boîtier (1).

7. Boîtier selon l'une des revendications 2 à 6, l'élément de liaison (15, 16) étant formé d'un seul tenant avec les petites pattes (2) reliées ou avec les petites pattes supplémentaires (3) reliées.

8. Boîtier selon l'une des revendications 2 à 7, l'élément de liaison (16) étant constitué d'un matériau électriquement isolant.

9. Boîtier selon l'une des revendications 1 à 8, des groupes de petites pattes (2) étant reliés mécaniquement entre eux sur un côté du boîtier (1) par le biais d'au moins un élément de liaison (16), un premier groupe comportant deux petites pattes (2) et un deuxième groupe trois petites pattes (3).
